(19) Europäisches Patentamt
European Patent Office
Office européen des brevets

(11) **EP 4 585 714 A2**

(12) **EUROPEAN PATENT APPLICATION**

(43) Date of publication:
**16.07.2025 Bulletin 2025/29**

(21) Application number: **24166297.2**

(22) Date of filing: **26.03.2024**

(51) International Patent Classification (IPC):
*C23C 16/02* (2006.01)     *C23C 16/34* (2006.01)
*C23C 16/455* (2006.01)     *H01L 21/02* (2006.01)
*H01L 21/285* (2006.01)     *C23C 16/52* (2006.01)

(52) Cooperative Patent Classification (CPC):
**C23C 16/45534; C23C 16/0272; C23C 16/34;
C23C 16/45527; C23C 16/52; H01L 21/02697;
H01L 21/28562**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.06.2023 JP 2023107405**

(71) Applicant: **Kokusai Electric Corp.
Tokyo 1010045 (JP)**

(72) Inventor: **OGAWA, Arito
Toyama-shi, Toyama, 939-2393 (JP)**

(74) Representative: **Bardehle Pagenberg
Partnerschaft mbB
Patentanwälte Rechtsanwälte
Prinzregentenplatz 7
81675 München (DE)**

(54) **METHOD OF PROCESSING SUBSTRATE, METHOD OF MANUFACTURING SEMICONDUCTOR DEVICE, PROGRAM, AND SUBSTRATE PROCESSING APPARATUS**

(57)     There is provided a technique that includes: (a) supplying a non-reducing promoting agent that promotes adsorption of a modifying agent containing an organic ligand to a substrate (200); (b) supplying the modifying agent to the substrate (200); and (c) forming a film on the substrate (200) after performing (a) and (b).

## FIG. 4

**Description**

CROSS-REFERENCE TO RELATED APPLICATION

This application is based upon and claims the benefit of priority from Japanese Patent Application No. 2023-107405, filed on June 29, 2023, the entire contents of which are incorporated herein by reference.

TECHNICAL FIELD

The present disclosure relates to a method of processing a substrate, a method of manufacturing a semiconductor device, a program, and a substrate processing apparatus.

BACKGROUND

In a related art, there are cases in which, a process of forming a metal-containing film on a substrate is performed as a process of manufacturing a semiconductor device.
When forming a film on the substrate, there is a possibility of reduced continuity of the film, leading to a deterioration in characteristics of the film formed on the substrate.

SUMMARY

Some embodiments of the present disclosure provide a technique capable of improving characteristics of a film formed on a substrate.
According to embodiments of the present disclosure, there is provided a technique that includes (a) supplying a non-reducing promoting agent that promotes adsorption of a modifying agent containing an organic ligand to the substrate; (b) supplying the modifying agent to the substrate; and (c) forming a film on the substrate after performing (a) and (b).

BRIEF DESCRIPTION OF DRAWINGS

The accompanying drawings, which are incorporated in and constitute a part of the specification, illustrate embodiments of the present disclosure.

FIG. 1 is a longitudinal cross-sectional view schematically illustrating a vertical process furnace of a substrate processing apparatus according to embodiments of the present disclosure.
FIG. 2 is a schematic cross-sectional view taken along line A-A in FIG. 1.
FIG. 3 is a schematic diagram of a controller of the substrate processing apparatus according to embodiments of the present disclosure, and is illustrating a control system of the controller in a block diagram.
FIG. 4 is a diagram illustrating a substrate-processing sequence according to embodiments of the present disclosure.
FIG. 5 is a top view illustrating a modification of the substrate processing apparatus according to embodiments of the present disclosure.

DETAILED DESCRIPTION

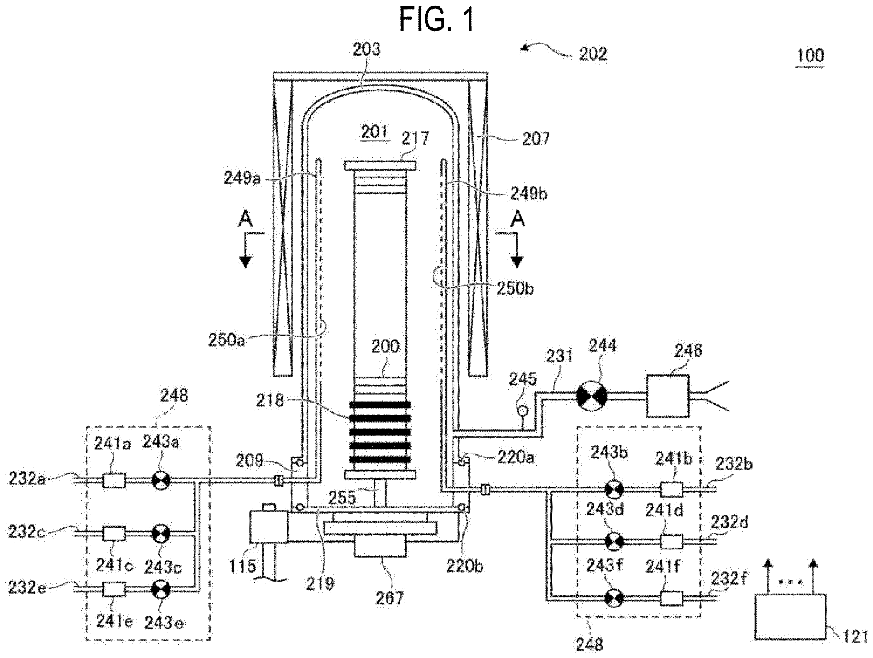

Reference will now be made in detail to various embodiments, examples of which are illustrated in the accompanying drawings. In the following detailed description, numerous specific details are set forth to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.
Hereinafter, embodiments of the present disclosure will be described mainly with reference to FIGS. 1 to 4. In addition, the drawings used in the following description are schematic, and the dimensional relationships of respective elements, the ratios of respective elements, and the like illustrated in the drawings may not correspond to actual ones. Further, the dimensional relationships of respective elements, the ratios of respective elements, and the like may not match among multiple drawings.

(1) Configuration of Substrate Processing Apparatus

As illustrated in FIG. 1, a process furnace 202 includes a heater 207 as a heating system (temperature adjuster).

The heater 207 is formed in a cylindrical shape. The heater 207 also functions as an activator (exciter) that activates (excites) a gas with heat.

A reaction tube 203 is disposed concentrically with the heater 207 inside the heater 207. The reaction tube 203 is made of a heat-resistant material such as, for example, quartz ($SiO_2$) or silicon carbide (SiC), and is formed in a cylindrical shape with an upper end closed thereof and a lower end thereof opened. A manifold 209 is disposed concentrically with the reaction tube 203 below the reaction tube 203. The manifold 209 is made of a metal such as stainless steel (SUS) or the like, and is formed in a cylindrical shape with upper and lower ends thereof opened. The upper end of the manifold 209 is engaged with the lower end of the reaction tube 203, thus being configured to support the reaction tube 203. An O-ring 220a as a sealing member is provided between the manifold 209 and the reaction tube 203. The reaction tube 203 is installed vertically, similar to the heater 207. A process container (reaction container) mainly includes the reaction tube 203 and the manifold 209. A process chamber 201 is formed in a hollow space of the process container. The process chamber 201 is configured to accommodate a plurality of wafers 200 as substrates.

Nozzles 249a and 249b are provided within the process chamber 201 to penetrate a sidewall of the manifold 209. Gas supply pipes (piping) 232a and 232b are respectively connected to the nozzles 249a and 249b.

On the gas supply pipes 232a and 232b, mass flow controllers (MFCs) 241a and 241b, which serve as flow rate controllers (flow rate control parts), and valves 243a and 243b, which serve as opening/closing valves, are respectively provided sequentially from an upstream side. Gas supply pipes 232c and 232e are connected to the gas supply pipe 232a at a downstream side of the valve 243a. On the gas supply pipes 232c and 232e, MFCs 241c and 241e and valves 243c and 243e are respectively provided sequentially from an upstream side. Gas supply pipes 232d and 232f are connected to the gas supply pipe 232b at a downstream side of the valve 243b. On the gas supply pipes 232d and 232f, MFCs 241d and 241f and valves 243d and 243f are respectively provided sequentially from an upstream side.

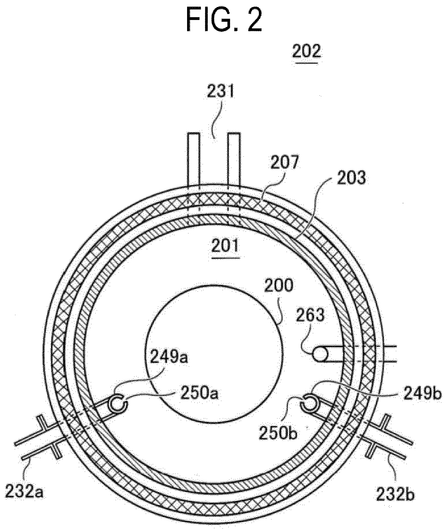

As illustrated in FIG. 2, the nozzles 249a and 249b are provided, respectively, to stand upright in an arrangement direction of the wafers 200 from a bottom to a top of an inner wall of the reaction tube 203 in a space of an annular shape in a plane view between the inner wall of the reaction tube 203 and the wafers 200. Gas supply holes 250a and 250b for supplying gases are respectively formed at side surfaces of the nozzles 249a and 249b. The gas supply holes 250a and 250b are respectively open to face a center of the reaction tube 203, to be capable of supplying gases toward the wafers 200. The gas supply holes 250a and 250b are provided at a plurality of positions from a bottom to a top of the reaction tube 203.

A precursor gas containing a halogen element is supplied from the gas supply pipe 232a into the process chamber 201 through the MFC 241a, valve 243a, and nozzle 249a.

A reaction gas containing a hydrogen element is supplied from the gas supply pipe 232b into the process chamber 201 through the MFC 241b, valve 243b, and nozzle 249b.

A promoting agent for promoting adsorption of a modifying agent is supplied from the gas supply pipe 232c into the process chamber 201 through the MFC 241c, valve 243c, and nozzle 249a. As the promoting agent, a non-reducing promoting agent is used.

In addition, the term "agent" used herein includes at least one selected from the group of gaseous and liquid substances. The liquid substance includes a mist-like substance. In other words, the modifying agent and promoting agent may contain a gaseous substance, may contain a liquid substance such as mist-like substance, or may contain both.

A modifying agent containing an organic ligand is supplied from the gas supply pipe 232d into the process chamber 201 through the MFC 241d, valve 243d, and nozzle 249b.

An inert gas is supplied from the gas supply pipes 232e and 232f into the process chamber 201 through the MFCs 241e and 241f, valves 243e and 243f, gas supply pipes 232a and 232b, and nozzles 249a and 249b respectively.

A precursor gas supply system mainly includes the gas supply pipe 232a, MFC 241a, and valve 243a. A reaction gas supply system mainly includes the gas supply pipe 232b, MFC 241b, and valve 243b. The precursor gas supply system and the reaction gas supply system may be collectively referred to as a gas supply system. Further, a promoting agent supply system, which serves as a first gas supply system, mainly includes the gas supply pipe 232c, MFC 241c, and valve 243c. A modifying agent supply system, which serves as a second gas supply system, mainly includes the gas supply pipe 232d, MFC 241d, and valve 243d. Further, an inert gas supply system mainly includes the gas supply pipes 232e and 232f, MFCs 241e and 241f, and valves 243e and 243f. The promoting agent supply system, modifying agent supply system, and inert gas supply system may be considered included in the gas supply system.

Any or the entirety of the various supply systems described above may be configured as an integrated supply system 248 in which the valves 243a to 243f, MFCs 241a to 241f, and the like are integrated. The integrated supply system 248 is connected to each of the gas supply pipes 232a to 232f, and is configured such that operations of supplying various gases into the gas supply pipes 232a to 232f, i.e., opening or closing operations of the valves 243a to 243f, flow rate regulating operations by the MFCs 241a to 241f, and the like are controlled by a controller 121, which will be described later. The integrated supply system 248 is configured as a monolithic or divided integrated unit, and is configured to be capable of being attached and detached to and from the gas supply pipes 232a to 232f, etc. at an integrated unit level, thus allowing maintenance, replacement, expansion, etc. of the integrated supply system 248 to be performed at the integrated unit level.

The reaction tube 203 is provided with an exhaust pipe 231 for exhausting atmosphere in the process chamber 201. The exhaust pipe 231 is connected to a vacuum pump 246, which serves as a vacuum-exhauster, through a pressure sensor 245, which serves as a pressure detector (pressure detection part) that detects pressure inside the process chamber 201, and an APC (Auto Pressure Controller) valve 244, which serves as a pressure regulator (pressure regulation part). The APC valve 244 is configured to perform vacuum-exhaust of an interior of the process chamber 201 or stop the vacuum-exhaust by being opened or closed in a state in which the vacuum pump 246 is in operation. The APC valve 244 is also configured to regulate the pressure inside the process chamber 201 by adjusting a valve-opening state based on pressure information detected by the pressure sensor 245 in a state in which the vacuum pump 246 is in operation. An exhaust system mainly includes the exhaust pipe 231, APC valve 244, and pressure sensor 245. The vacuum pump 246 may be considered included in the exhaust system.

A seal cap 219 is provided below the manifold 209 and serves as a furnace opening lid capable of airtightly closing an opening at a lower end of the manifold 209. The seal cap 219 is made of, for example, a metal such as SUS or the like, and is formed in a disc shape. An O-ring 220b is provided on an upper surface of the seal cap 219 and serves as a sealing member abutting against the lower end of the manifold 209. A rotator 267 is installed below the seal cap 219 to rotate a boat 217 to be described later. A rotating shaft 255 of the rotator 267 passes through the seal cap 219 and is connected to the boat 217. The rotator 267 is configured to rotate the wafers 200 by rotating the boat 217. The seal cap 219 is configured to be raised or lowered in a vertical direction by a boat elevator 115, which is as an elevator installed outside the reaction tube 203. The boat elevator 115 is configured to be capable of loading or unloading the boat 217 into or out of the process chamber 201 by raising or lowering the seal cap 219. The boat elevator 115 is configured as a transporter (transport mechanism) that transports the boat 217, i.e., the wafers 200, into or out of the process chamber 201.

The boat 217, which serves as a substrate support, is configured to vertically align and support a plurality of wafers 200, for example, 25 to 200 wafers, in multiple stages, i.e., arrange the wafers 200 at intervals, in a horizontal posture with centers thereof aligned with one another. The boat 217 is made of, for example, a heat-resistant material such as quartz or SiC. Heat-insulating plates 218, which are made of, for example, a heat-resistant material such as quartz or SiC, are supported in multiple stages in a lower region of the boat 217. In addition, the notation of numerical ranges such as "25 to 200" herein implies that the lower and upper limit values are included in that range. Thus, for example, "25 to 200" implies "25 or more and 200 or fewer." The same is applied to other numerical ranges.

A temperature sensor 263, which serves as a temperature detector, is installed within the reaction tube 203. By regulating a state of supply of electric power to the heater 207 based on temperature information detected by the temperature sensor 263, a temperature inside the process chamber 201 becomes a desired temperature distribution. The temperature sensor 263 is formed in an L-shape and is installed along the inner wall of the reaction tube 203.

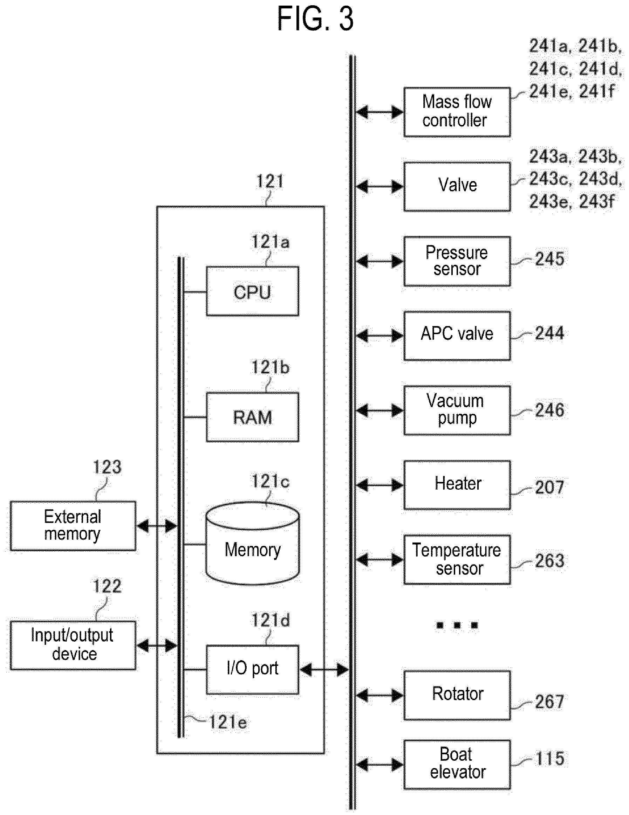

As illustrated in FIG. 3, the controller 121, which is a control part (control means), is configured as a computer including a CPU (Central Processing Unit) 121a, a RAM (Random Access Memory) 121b, a memory 121c, and an I/O port 121d. The RAM 121b, memory 121c, and I/O port 121d are configured to be capable of exchanging data with the CPU 121a via an internal bus 121e. An input/output device 122 including, for example, a touch panel or the like is connected to the controller 121. In addition, the substrate processing apparatus may be configured to include one controller, or may be configured to include a plurality of controller. In other words, control for performing a processing sequence to be described later may be performed using a single controller, or may be performed using a plurality of controller. Further, the plurality of controllers may be configured as a control system by being connected to each other through wired or wireless communication networks, and the control for performing the processing sequence as described later may be performed by the entire control system. When the term "controller" is used herein, it may refer to a single controller, a plurality of controllers, or a control system constituted by a plurality of controllers.

The memory 121c includes, for example, a flash memory, an HDD (Hard Disk Drive), or the like. The memory 121c stores, in a readable manner, a control program for controlling operations of the substrate processing apparatus 100, a process recipe including procedures, conditions, etc. of substrate processing to be described later, and the like. The process recipe is a combination that enables the controller 121 to execute each procedure in the substrate processing described later to obtain predetermined results, and functions as a program. Hereinafter, the term "program" is used to collectively refer to the process recipe, control program, and the like. Further, the process recipe may be simply referred to as a recipe. When the term "program" is used herein, it may refer to a case of including the recipe, a case of including the control program, or a case of including both of them. The RAM 121b is configured as a memory area (work area) in which programs, data, etc. read by the CPU 121a are temporarily held.

The I/O port 121d is connected to the above-described MFCs 241a to 241f, valves 243a to 243f, pressure sensor 245, APC valve 244, vacuum pump 246, heater 207, temperature sensor 263, rotator 267, boat elevator 115, etc.

The CPU 121a is configured to read and execute the control program from the memory 121c and to read the recipe from the memory 121c in response to an input of an operation command and the like from the input/output device 122. The CPU 121a is configured to control, for example, the flow rate regulating operations of various gases by the MFCs 241a to 241f, the opening or closing operations of the valves 243a to 243f, the opening or closing operation of the APC valve 244, the pressure regulating operation by the APC valve 244 based on the pressure sensor 245, the startup and shutdown of the vacuum pump 246, the temperature regulating operation of the heater 207 based on the temperature sensor 263, the rotation and rotational speed adjusting operation of the boat 217 by the rotator 267, the raising and lowering operation of the boat 217 by the boat elevator 115, and the like, according to the contents of the recipe thus read.

The controller 121 may be configured by installing, on the computer, the above-described program stored in an external memory 123. The external memory 123 includes, for example, a magnetic disk such as a hard disk or the like, an optical disk such as a CD or the like, a magnetooptical disk such as an MO or the like, and a semiconductor memory such as a USB memory or the like. The memory 121c or the external memory 123 is configured as computer-readable recording medium storing the program. Hereinafter, the memory 121c and the external memory 123 are collectively and simply referred to as "recording medium". When the term "recording medium" is used herein, it may refer to a case including the memory 121c, a case including the external memory 123, or a case including both of them. In addition, the program may be provided to the computer by using a communication means such as the Internet or a dedicated line without using the external memory 123.

(2) Substrate Processing Process

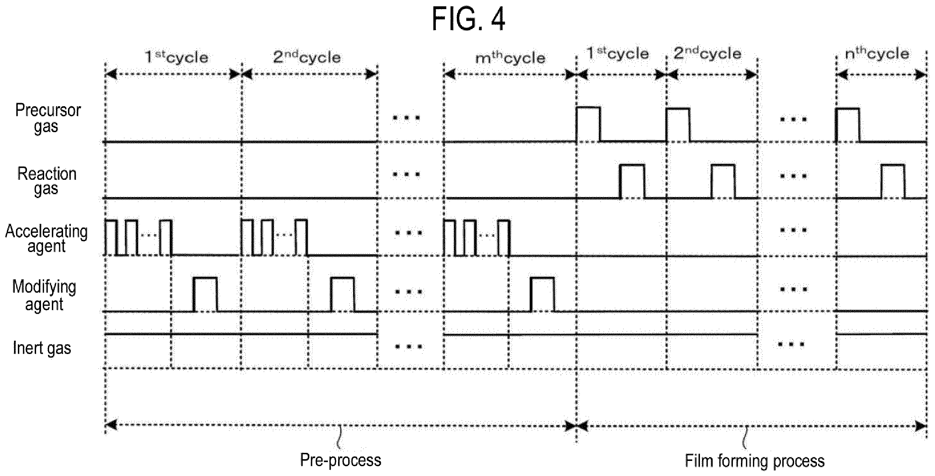

As one of processes of manufacturing semiconductor devices, an example of a process of forming a thin film on the wafer 200 will be described with reference to FIG. 4. In the following description, the operation of each component included in the substrate processing apparatus 100 is controlled by the controller 121.

The term "wafer" as used herein may refer to "a wafer itself" or "a stacked body of a wafer and a predetermined layer or film formed on the surface of the wafer." The term "a surface of a wafer" as used herein may refer to "a surface of a wafer itself" or "a surface of a predetermined layer or the like formed on a wafer." When it is stated herein "a predetermined layer is formed on a wafer," it may refer to "a predetermined layer is directly formed on a surface of a wafer itself" or "a predetermined layer is formed on a layer or the like formed on a wafer." The term "substrate" as used herein is equivalent to the term "wafer."

(Wafer Loading)

When the plurality of wafers 200 are loaded onto the boat 217 (wafer charging), as illustrated in FIG. 1, the boat 217 supporting the plurality of wafers 200 is raised by the boat elevator 115 and is loaded into the process chamber 201 (boat loading), thus being accommodated in the process container. In this state, the seal cap 219 closes the opening at the lower end of the manifold 209 via the O-ring 220b.

(Pressure Regulating and Temperature Regulating)

The interior of the process chamber 201, i.e., a space where the wafers 200 are present is vacuum-exhausted to a desired pressure (degree of vacuum) by the vacuum pump 246. At this time, the pressure inside the process chamber 201 is measured by the pressure sensor 245, and the APC valve 244 is feedback-controlled based on the pressure information measured (pressure regulating). The vacuum pump 246 is maintained in a constantly operated state at least until the wafers 200 are completely processed. Further, the interior of the process chamber 201 is heated to a desired temperature by the heater 207. At this time, the state of supply of electric power to the heater 207 is feedback-controlled based on the temperature information detected by the temperature sensor 263, so that the interior of the process chamber 201 exhibits a desired temperature distribution (temperature regulating). The heating of the interior of the process chamber 201 by the heater 207 continues at least until the wafers 200 are completely processed.

[Pre-Process]

(Promoting Agent Time-Division Supply, First Step)

First, in this step, the promoting agent is supplied in a time divisional manner. In other words, the supply of the promoting agent is performed a predetermined number of times (one or more times, particularly a plurality of times). Specifically, a promoting agent supply process of opening the valve 243c to supply the promoting agent into the gas supply pipe 232c and a promoting agent removal process of closing the valve 243c to stop the supply of the promoting agent and removing the promoting agent from the process chamber 201 are performed in this order a predetermined number of times (p times, where p is an integer of 1 or more). In other words, the supply and stop of the promoting agent (also referred to as exhaust and purge) are performed alternately in a time divisional manner.

In the promoting agent supply process, the promoting agent is regulated in flow rate by the MFC 241c. The promoting agent is then supplied into the process chamber 201 through the nozzle 249a and discharged through the exhaust pipe 231. At this time, the valve 243e may be simultaneously opened to flow an inert gas into the gas supply pipe 232e. Further, to prevent ingress of the promoting agent into the nozzle 249b, the valve 243f may be opened to flow the inert gas into the gas supply pipe 232f. Further, in the promoting agent removal process, the APC valve 244 of the exhaust pipe 231 remains open, and the interior of the process chamber 201 is vacuum-exhausted by the vacuum pump 246 to remove the promoting agent from the wafers 200 and to eliminate any residual unreacted promoting agent or reaction by-products from the process chamber 201. At this time, the valves 243e and 243f remain open to maintain the supply of the inert gas as a purge gas into the process chamber 201.

In addition, "time division" herein implies temporal division (separation). For example, "supplying the promoting agent in a time divisional manner" herein implies that the promoting agent is not continuously supplied. In other words, it implies that the promoting agent is supplied in a pulse manner. In addition, the promoting agent may be supplied intermittently.

At this time, a main gas supplied in a time divisional manner into the process chamber 201 is the promoting agent. In this way, by supplying the promoting agent to the wafer 200 a plurality of times, it is possible to adsorb the promoting agent on the wafer 200 without a gap.

As the promoting agent, a non-reducing, i.e., oxidizing gas is used. Examples of the oxidizing gas may include an oxygen $(O_2)$ gas, ozone $(O_3)$ gas, water vapor $(H_2O$ gas), hydrogen peroxide $(H_2O_2)$ gas, hydrogen $(H_2)$ gas + oxygen $(O_2)$ gas, etc. One or more of these gases may be activated and used as the promoting agent. An activated gas refers to a gas that is activated either by plasma or thermally. The same is applied below.

In addition, the simultaneous mention of two gases such as "$H_2$ gas + $O_2$ gas" herein implies a mixed gas of $H_2$ gas and $O_2$ gas. When supplying a mixed gas, two gases may be mixed (pre-mixed) in a supply pipe before being supplied into the process chamber 201. Alternatively, two gases may be separately supplied into the process chamber 201 from different supply pipes, thus being mixed (post-mixed) within the process chamber 201.

Further, an oxidizing gas not containing a hydrogen element (H) may be used as the promoting agent. Examples of the oxidizing gas not containing H may include an $O_2$ gas, $O_3$ gas, etc. One or more of these gases may be activated and used as the promoting agent.

As the inert gas, for example, a nitrogen $(N_2)$ gas, or a rare gas such as an argon (Ar) gas, helium (He) gas, neon (Ne) gas, and xenon (Xe) gas, or the like may be used. One or more of these gases may be used as the inert gas.

By supplying the promoting agent, atoms or molecules that promote the adsorption of the modifying agent containing an organic ligand are adsorbed on the wafer 200 (base film on the surface). Specifically, supplying, for example, the oxidizing gas as the promoting agent leads to the adsorption of an oxygen group (hereinafter also referred to as "O-") and $O_2$ on the wafer 200. In other words, the surface of the wafer 200 is terminated with O- and $O_2$. In addition, in the present disclosure, "termination" or "adsorption" may also include a state where the entire surface of the wafer 200 is not covered. There may be cases where the entire surface of the wafer 200 is not covered depending on supply conditions of the gas or a surface state of the wafer 200. Further, there may be cases where the entire surface of the wafer 200 is not covered due to self-limiting reaction stop. In the present disclosure, supplying the promoting agent a plurality of times may increase an amount of the promoting agent adsorbed on the wafer 200. In other words, it may approach a state where the promoting agent is adsorbed on the entire possible adsorption sites for the promoting agent.

In the first step, the pressure inside the space (process chamber 201) on the wafer 200 is set to, for example, a pressure within a range of 1 to 3990 Pa. A supply flow rate of the promoting agent controlled by the MFC 241c is set to, for example, a flow rate within a range of 0.01 to 5.0 slm. In the following, a temperature of the heater 207 is set to, for example, a temperature at which a temperature of the wafer 200 is within a range of, for example, 300 to 550 degrees C. In addition, the notation of numerical ranges such as "1 to 3990 Pa" herein implies that the lower and upper limit values are included in that range. Accordingly, for example, "1 to 3990 Pa" implies "1 Pa or more and 3990 Pa or less". The same is applied to other numerical ranges.

(Purge, Second Step)

After a predetermined time is passed from a start of the time-division supply of the promoting agent, the valve 243c is closed to stop the supply of the promoting agent. At this time, the APC valve 244 of the exhaust pipe 231 remains open, and the interior of the process chamber 201 is vacuum-exhausted by the vacuum pump 246 to remove any residual gas from the wafer 200 and to eliminate any unreacted promoting agent or reaction by-products from the process chamber 201. At this time, the valves 243e and 243f remain open to maintain the supply of the inert gas as the purge gas into the process chamber 201. The inert gas acts as the purge gas, enhancing the removal of the residual gas from the wafer 200 and the elimination of any unreacted promoting agent or reaction by-products from the process chamber 201.

In the second step, a supply flow rate of the inert gas controlled by the MFCs 241e and 241f is set to, for example, 0.1 to 10 slm.

(Modifying Agent Supply, Third Step)

The valve 243d is opened to flow the modifying agent into the gas supply pipe 232d. The modifying agent is regulated in flow rate by the MFC 241d. The modifying agent is then supplied into the process chamber 201 through the gas supply hole 250b of the nozzle 249b and discharged through the exhaust pipe 231. At this time, the valve 243f may be simultaneously opened to flow the inert gas into the gas supply pipe 232f. Further, to prevent ingress of the modifying agent into the nozzle 249a, the valve 243e may be opened to flow the inert gas into the gas supply pipe 232e.

At this time, a main gas flowing into the process chamber 201 is the modifying agent. In other words, the modifying agent is supplied to the wafer 200.

As the modifying agent, a gas containing an organic ligand as well as an organic compound is used. Examples of the gas containing the organic compound may include gases containing a hydrocarbon group (CH-), an amine group (NH-), or the like.

A gas not containing a metal element is used as the gas containing the organic compound. Examples of the gas not containing the metal element may include a gas containing at least one selected from the group of an ether compound, ketone compound, amine compound containing an amine, and organic hydrazine compound. As the gas containing the ether compound, a gas containing at least one selected from the group of dimethyl ether, diethyl ether, methyl ethyl ether, propyl ether, isopropyl ether, furan, tetrahydrofuran, pyran, tetrahydropyran, and the like may be used. As the gas containing the ketone compound, a gas containing at least one selected from the group of dimethyl ketone, diethyl ketone, methyl ethyl ketone, methyl propyl ketone, and the like may be used. As the gas containing the amine compound, a gas containing at least one selected from the group of a methylamine compound such as monomethylamine ($CH_3NH_2$, also referred to as methylamine), dimethylamine, and trimethylamine, an ethylamine compound such as monoethylamine, diethylamine, and triethylamine, and a methylethylamine compound such as dimethylethylamine and methyldiethylamine may be used. As the gas containing the organic hydrazine compound, a gas containing at least one selected from the group of methylhydrazine-based gases such as monomethylhydrazine, dimethylhydrazine, and trimethylhydrazine may be used. One or more of these may be used as the modifying agent.

Further, a gas containing a metal element is used as the gas containing the organic compound. Examples of the gas containing the metal element may include a trimethylaluminum (($CH_3)_3Al$) gas, trimethylgallium (($CH_3)_3Ga$) gas, trimethylindium (($CH_3)_3In$) gas, etc. One or more of these may be used as the modifying agent.

By supplying the modifying agent, some of the modifying agent reacts with the O-, $O_2$, etc. on the wafer 200, resulting in generation of reaction by-products such as $H_2O$ and adsorption of an amine group or hydrocarbon group, e.g., an alkyl group such as methyl group ($CH_3$-), ethyl group ($C_2H_5$-), propyl group, or isopropyl group, etc. The supply of the modifying agent may increase the adsorption of the hydrocarbon group or amine group on the wafer 200. In a film formation process to be described later, by supplying the precursor gas to the wafer 200 with the adsorbed hydrocarbon group or amine group, the halogen element contained in the precursor gas reacts with the hydrocarbon group or amine group present on the wafer 200, which results in adsorption of molecules, with less steric hindrance, on the wafer 200 due to a fewer number of molecules than in the precursor gas, leading to formation of a continuous film with a higher adsorption of a precursor element.

Specifically, when using, for example, the oxidizing gas, i.e. $O_2$ gas as the promoting agent and using, for example, the $CH_3NH_2$ gas as the modifying agent, the supply of the $CH_3NH_2$ gas causes the O and $O_2$ adsorbed on the wafer 200 to react with $CH_3NH_2$, resulting in release of the O and $O_2$ from the wafer 200 and the generation and discharge of $H_2O$. Then, the amine group or hydrocarbon group such as ($CH_3$)-, ($CH_3$)N-, or ($CH_3$)NH- is adsorbed and remains on the wafer 200. At this time, although some of the O and $O_2$ may remain on the wafer 200, the presence thereof at an interface between an underlying oxide film and a film formed in a film formation process to be described later is considered to impose minimal impact on device characteristics. Then, when using, for example, a titanium tetrachloride ($TiCl_4$) gas as the precursor gas, in the film formation process to be described later, Cl contained in the $TiCl_4$ gas reacts with ($CH_3$)-, ($CH_3$)N-, ($CH_3$)NH-, etc. on the wafer 200, resulting in release and discharge of ($CH_3$)Cl, ($CH_3$)NCl, or ($CH_3$)NHCl from the wafer 200. In other words, the generation of reaction by-products such as hydrogen chloride (HCl), which inhibits the adsorption of the precursor element, is prevented.

In the third step, the pressure of the process chamber 201 is set to, for example, a pressure within a range of 1 to 3990 Pa. A supply flow rate of the modifying agent controlled by the MFC 241d is set to, for example, a flow rate within a range of 0.01 to 5.0 slm.

(Purge, Fourth Step)

After a predetermined time is passed from a start of the supply of the modifying agent, the valve 243d is closed to stop the supply of the modifying agent. At this time, the APC valve 244 of the exhaust pipe 231 remains open, and the interior of the process chamber 201 is vacuum-exhausted by the vacuum pump 246 to remove any residual gas from the wafer 200 and to eliminate any unreacted modifying agent or reaction by-products from the process chamber 201. At this time, the valves 243e and 243f remain open to maintain the supply of the inert gas as the purge gas into the process chamber 201. A supply amount of the inert gas supplied in the fourth step may be the same as that in the second step. Further, a purge degree (supply amount of the inert gas) may be appropriately regulated based on the gas remaining in the process chamber 201. Herein, the supply amount refers to a supply flow rate set by the MFC, a supply time, or both.

(Implementation for Predetermined Number of Times, Fifth Step)

A cycle of the above-described first to fourth steps in this order is performed a predetermined number of times (m times, where m is an integer of 1 or more) to adsorb the hydrocarbon group, amine group, or the like on the wafer 200. Herein, the amine group or hydrocarbon group such as, for example, $(CH_3)-$, $(CH_3)N-$, or $(CH_3)NH-$ is adsorbed on the wafer 200. This prevents the generation of reaction by-products such as HCl, which inhibit the adsorption of the precursor element, by supplying the precursor gas and reaction gas in the film formation process to be described later.

The processing in the above pre-process may be represented as follows for convenience. The same notation will be used in the description of other embodiments and the like below. Herein, "→" indicates a sequential flow.

$$((\text{Promoting Agent Supply} \to \text{Purge}) \times p \to \text{Purge} \to \text{Modifying Agent} \to \text{Purge}) \times m$$

(m and p are integers of 1 or 2 or more, respectively)

In addition, an example of supplying the modifying agent for once is described herein, but the present disclosure is not limited to this, and the modifying agent may also be supplied as (Modifying Agent Supply → Purge) × o (where o is an integer of 1 or more). By setting o to 2 or more, an amount of the modifying agent adsorbed on the surface of the wafer 200 may be increased. Further, by purging, it is possible to remove the by-products generated when supplying the modifying agent from the space where the wafer 200 exists, thereby increasing an amount of the modifying agent that reaches the surface of the wafer 200.

[Film formation Process]

After performing the above-described pre-process, the film formation process of forming a film on the wafer 200 is performed.

(Precursor Gas Supply, Sixth Step)

The valve 243a is opened to flow a precursor gas into the gas supply pipe 232a. The precursor gas is regulated in flow rate by the MFC 241a. The precursor gas is then supplied into the process chamber 201 through the gas supply hole 250a of the nozzle 249a and discharged through the exhaust pipe 231. At this time, the valve 243e may be simultaneously opened to flow the inert gas into the gas supply pipe 232e. At this time, to prevent ingress of the precursor gas into the nozzle 249b, the valve 243f may be opened to flow the inert gas into the gas supply pipe 232f.

At this time, a main gas flowing into the process chamber 201 is the precursor gas. In other words, the precursor gas is supplied to the wafer 200.

As the precursor gas, a gas containing a halogen element may be used. Examples of the gas containing the halogen element may include a gas containing at least one selected from the group of fluorine (F), chlorine (Cl), bromine (Br), iodine (I), etc. One or more of these gases may be used as the precursor gas.

Further, a gas containing a halogen element and metal element may be used as the precursor gas. Herein, the metal element includes at least one selected from the group of a transition metal of Group 3 to Group 12 elements, Group 13 element (e.g., aluminum (Al), gallium (Ga), indium (In)), silicon (Si) element, and the like.

As the gas containing the halogen element and Group 13 element, for example, an aluminum trichloride ($AlCl_3$) gas, etc. may be used. As the gas containing the halogen element and Si element, for example, a silicon tetrachloride ($SiCl_4$) gas, dichlorosilane ($SiH_2Cl_2$) gas, hexachlorodisilane ($Si_2Cl_6$) gas, etc. may be used.

As the gas containing the halogen element and transition metal, for example, a gas containing the halogen element and at least one selected from the group of a Group 3 element such as yttrium (Y) or lanthanum (La), Group 4 element such as cerium (Ce), titanium (Ti), zirconium (Zr), or hafnium (Hf), Group 5 element, and Group 6 element such as chromium (Cr), molybdenum (Mo), or tungsten (W) may be used. Examples of the gas containing the halogen element and transition metal may include a $TiCl_4$ gas, hafnium tetrachloride ($HfCl_4$) gas, zirconium tetrachloride ($ZrCl_4$) gas, tungsten hexafluoride ($WF_6$) gas, tungsten hexachloride ($WCl_6$) gas, molybdenum pentachloride (MoCls) gas, molybdenum dichloride dioxide ($MoO_2Cl_2$) gas, molybdenum tetrachloride oxide ($MoOCl_4$) gas, molybdenum hexafluoride ($MoF_6$) gas, molybdenum difluoride dioxide ($MoO_2F_2$) gas, and molybdenum tetrafluoride oxide ($MoOF_4$) gas. One or more of these may be used as the gas containing the halogen element and transition metal.

At this time, the precursor gas containing the halogen element is supplied to the wafer 200 with the adsorbed hydrocarbon group, amine group or the like, which is derived from the gas containing the organic ligand, i.e., the wafer 200 on which the surface is terminated by the hydrocarbon group or amine group. Herein, the hydrocarbon group or amine group is adsorbed on the wafer 200 in the pre-process before the film formation process is started.

With the supply of the precursor gas, the precursor gas is supplied to the wafer 200 with an exposed organic ligand such as the hydrocarbon group or amine group. This causes the halogen element contained in the precursor gas to react with the hydrocarbon group or amine group present on the wafer 200, resulting in the adsorption of the precursor element with a smaller molecular size than that of the precursor gas, on the wafer 200. Therefore, there is less steric hindrance compared to the case where the precursor gas is adsorbed. In other words, the precursor element with a small molecular size is adsorbed on the wafer 200 (base film on the surface), increasing an adsorption density of the precursor element on the wafer 200, which may allow for a formation of a precursor-containing layer with a high content of the precursor element. In addition, at this time, $(CH_3)Cl$, $(CH_3)NCl$, or $(CH_3)NHCl$ is generated as by-products. Most of these by-products is released and discharged from the wafer 200. In other words, the generation of reaction by-products such as hydrogen chloride (HCl), which inhibits the adsorption of the precursor element, is prevented.

Specifically, as described above, in this step, when using, for example, a $TiCl_4$ gas as the precursor gas, Cl in the $TiCl_4$ gas reacts with $(CH_3)$-, $(CH_3)NH$-, etc. on the wafer 200, resulting in the release of $(CH_3)Cl$, $(CH_3)NCl$, $(CH_3)NHCl$, etc. from the wafer 200. Then, $TiCl_x$ (where x is less than 4) is adsorbed on the wafer 200. In other words, $TiCl_x$ with less steric hindrance compared to the adsorption of $TiCl_4$ is adsorbed on the wafer 200, increasing an adsorption density of a Ti element on the wafer 200, which may allow for a formation of a Ti-containing layer with a high content of the Ti element.

In the sixth step, the APC valve 244 is regulated such that the pressure inside the process chamber 201 is set to, for example, a pressure within a range of 1 to 3990 Pa. A supply flow rate of the precursor gas controlled by the MFC 241a is set to, for example, a flow rate within a range of 0.1 to 2.0 slm. A supply time of the precursor gas to the wafer 200 is set to, for example, a time within a range of 0.01 to 30 seconds.

(Purge, Seventh Step)

After a predetermined time is passed from a start of the supply of the precursor gas, the valve 243a is closed to stop the supply of the precursor gas. At this time, the APC valve 244 of the exhaust pipe 231 remains open, and the interior of the process chamber 201 is vacuum-exhausted by the vacuum pump 246 to remove any residual gas from the wafer 200 and to eliminate any unreacted precursor gas or reaction by-products from the process chamber 201. At this time, the valves 243e and 243f remain open to maintain the supply of the inert gas as the purge gas into the process chamber 201. The seventh step may be performed under conditions similar to other purge steps.

(Reaction Gas Supply, Eighth Step)

After a predetermined time is passed from a start of the purge, the valve 243b is opened to flow a reaction gas into the gas supply pipe 232b. The reaction gas is regulated in flow rate by the MFC 241b. The reaction gas is then supplied into the process chamber 201 through the gas supply hole 250b of the nozzle 249b and discharged through the exhaust pipe 231. In addition, at this time, the valve 243f may be simultaneously opened to flow the inert gas into the gas supply pipe 232f. Further, to prevent ingress of the reaction gas into the nozzle 249a, the valve 243e may be opened to flow the inert gas into the gas supply pipe 232e.

At this time, a main gas flowing into the process chamber 201 is the reaction gas. In other words, the reaction gas is supplied to the wafer 200.

As the reaction gas, for example, a H-containing gas that contains a hydrogen element (H) may be used. Examples of the H-containing gas may include a $H_2$ gas, ammonia ($NH_3$) gas, hydrazine ($N_2H_4$) gas, diazene ($N_2H_2$) gas, $H_2O$ gas, $H_2O_2$ gas, a mixed gas of $H_2 + O_2$, deuterium ($D_2$) gas, heavy ammonia ($ND_3$) gas, monosilane ($SiH_4$) gas, disilane ($Si_2H_6$) gas, trisilane ($Si_3H_8$) gas, monoborane ($BH_3$) gas, diborane ($B_2H_6$) gas, $B_3H_8$ gas, phosphine ($PH_3$) gas, etc. One or more of these activated gases may be used as the reaction gas.

By supplying the reaction gas, at least a portion of a first layer formed on the wafer 200 undergoes a substitution reaction with the reaction gas, forming a second layer. Specifically, when using, for example, an $NH_3$ gas as the reaction gas, the supply of the $NH_3$ gas causes the $NH_3$ gas to undergo a substitution reaction with at least a portion of the Ti-containing layer formed on the wafer 200. During the substitution reaction, Ti contained in the Ti-containing layer combines with N contained in the $NH_3$ gas, forming a TiN layer on the wafer 200. Further, during the substitution reaction, the adsorption of the halogen element is reduced in the pre-process and the adsorption of Ti is increased in the film formation process, so that the generation of reaction by-products such as HCl is prevented.

In the eighth step, the APC valve 244 is regulated such that the pressure inside the process chamber 201 is set to, for example, a pressure within a range of 1 to 3990 Pa. A supply flow rate of the reaction gas controlled by the MFC 241b is set to, for example, a flow rate within a range of 0.1 to 30 slm. A supply time of the reaction gas to the wafer 200 is set to, for example, a time within a range of 0.01 to 30 seconds.

(Purge, Ninth Step)

After a predetermined time is passed from a start of the supply of the reaction gas, the valve 243b is closed to stop the supply of the reaction gas. At this time, the APC valve 244 of the exhaust pipe 231 remains open, and the interior of the process chamber 201 is vacuum-exhausted by the vacuum pump 246 to remove any residual gas from the wafer 200 and to eliminate any unreacted reaction gas, residual reaction gas contributed to the formation of the second layer, or reaction by-products, from the process chamber 201. At this time, the valves 243e and 243f remain open to maintain the supply of the inert gas as the purge gas into the process chamber 201.
In other words, the unreacted reaction gas, residual reaction gas contributed to the formation of the second layer, or the above-described reaction by-products remaining in the process chamber 201 are eliminated from the interior of the process chamber 201. The inert gas acts as the purge gas.
The ninth step may be performed under conditions similar to other purge steps.

(Implementation of Predetermined Number of Times, Tenth Step)

A cycle of the above-described sixth to ninth steps in this order is performed a predetermined number of times (n times, where n is an integer of 1 or more) to form a predetermined film with a predetermined thickness on the wafer 200. Herein, a metal-containing film, for example, a titanium nitride (TiN) film is formed as the predetermined film.
The above processing in the film formation process may be represented as follows.

$$(\text{Precursor Gas} \rightarrow \text{Purge} \rightarrow \text{Reaction Gas} \rightarrow \text{Purge}) \times n$$

(where n is an integer of 1 or more)

(Implementation for Predetermined Number of Times, Eleventh Step)

After performing the tenth step described above, the process returns to the first step. Then, a cycle of the above-described fifth step and tenth step in this order is performed a predetermined number of times (q times, where q is an integer of 1 or more) to form a predetermined film with a predetermined thickness on the wafer 200. Herein, a metal-containing film, for example, a titanium nitride (TiN) film, is formed as the predetermined film.
Therefore, the processing in the above substrate processing process may be represented as follows.

[((Promoting Agent Supply → Purge 1) × p → Purge 2 → Modifying Agent → Purge 3) × m → (Precursor Gas → Purge 4 → Reaction Gas → Purge 5) × n] × q (where, p, m, n, and q are integers of 1 or 2 or more, may be different numbers, and are adjusted appropriately). In addition, here, Purge 1, Purge 2, and Purge 3 may not be performed here.

(After Purge and Return to Atmospheric Pressure)

The inert gas is supplied into the process chamber 201 from each of the gas supply pipes 232e and 232f, and is discharged from the exhaust pipe 231. The inert gas acts as the purge gas, which allows the interior of the process chamber 201 to be purged with the inert gas, resulting in the removal of any residual gas or reaction by-products from the interior of the process chamber 201 (after purge). Thereafter, the atmosphere inside the process chamber 201 is substituted with the inert gas (inert gas substitution), so that the pressure inside the process chamber 201 is returned to normal pressure (atmospheric pressure recovery).

(Wafer Unloading)

After that, the seal cap 219 is lowered by the boat elevator 115 to open the lower end of the manifold 209. Then, the completely processed wafer 200 is unloaded from the lower end of the manifold 209 to outside the reaction tube 203 while being supported on the boat 217 (boat unloading). After that, the processed wafer 200 is taken out from the boat 217 (wafer discharge).
Herein, a film formed on the wafer 200 using a substrate processing sequence without the pre-process may grow in an island-like manner instead of becoming a continuous film. In other words, the adsorption of the precursor element on the wafer 200 becomes insufficient, resulting in poor coverage. In contrast, a film formed on the wafer 200 using the above-described substrate processing sequence exhibits small crystal grains, high density, and continuous growth, resulting in a high coverage rate.

In other words, by performing the pre-process before the film formation process, it is possible to promote the adsorption of the precursor element on the wafer 200, to increase the adsorption density of the precursor element, and to form a film with a high content of the precursor element.

In other words, by supplying the promoting agent and modifying agent before film formation, it is possible to promote the adsorption of the precursor element on the surface of the wafer, resulting in a formation of a thin film with a high coverage rate.

(3) Effects of Present Embodiment

According to the present embodiments, one or more of the following effects are obtained.

(a) It is possible to improve characteristics of the film formed on the substrate.
(b) It is possible to continuously grow the film formed on the substrate. Herein, "continuous" implies that crystals of a film material are linked, that crystal spacings are small, etc.
(c) It is possible to increase the adsorption density of the precursor element, and thus to improve the coverage rate.
(d) It is possible to prevent the generation of the reaction by-products that inhibit the adsorption of the precursor element such as HCl in the film formation process.

(4) Other Embodiments

Embodiments of the present disclosure are specifically described above. However, the present disclosure is not limited to the above-described embodiments, and may be changed in various ways without departing from the gist of the present disclosure.

(Modification 1)

In this modification, an organic-based gas is used as the promoting agent used in the above pre-process. As the organic-based gas, for example, a gas containing an alkane is used. The gas containing alkane is composed of $C_nH_{2n+2}$, and examples thereof may include methane ($CH_4$), ethane ($C_2H_6$), propane ($C_3H_8$), etc. One or more of these may be used as the promoting agent.

By supplying the organic-based gas as the promoting agent, a hydrocarbon group is adsorbed on the wafer 200. In other words, by supplying the organic-based gas, the surface of the wafer 200 is terminated with CH-. This promotes the adsorption of the modifying agent. In addition, when using the organic-based gas, a possibility of excessively altering the state of an exposed film on the surface of the wafer 200 may be reduced. For example, when the surface of the wafer 200 includes a film containing a metal element, using the oxidizing gas of the present disclosure may lead to a formation of an oxide film containing a metal element. The formation of the oxide film may affect characteristics of semiconductor devices. On the other hand, when using the organic-based gas, it is possible to prevent such issues. In addition, if an exposed film on the surface of the wafer 200 contains oxygen, the use of the oxidizing gas of the present disclosure is less likely to cause such issues.

In this case as well, effects similar to the substrate processing sequence illustrated in FIG. 4 described above may be obtained.

(Modification 2)

In this modification, the processing in the above film formation process is performed as described below. "+" indicates that there is a simultaneous flow timing. "()" indicates that it may be omitted.

[Precursor Gas → Precursor Gas + Reducing gas → (Reducing gas) → Purge → Reaction Gas → Purge] × n (where n is an integer of 1 or more)

In this case as well, effects similar to the substrate processing sequence illustrated in FIG. 4 described above may be obtained.

Specifically, for example, a $TiCl_4$ gas may be used as the precursor gas, an $NH_3$ gas may be used as the reaction gas, and a $SiH_4$ gas may be used as the reducing gas. The above sequence may be suitably applied to form a TiN film, etc.

(Modification 3)

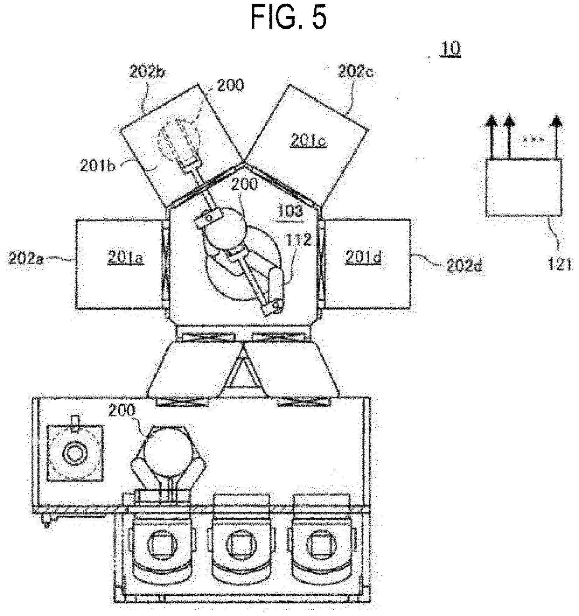

The above embodiments describe the case where the substrate processing sequence described above is performed continuously (in-situ) within a same process chamber (process container). The present disclosure is not limited to the above-described embodiments. For example, as illustrated in FIG. 5, it may be performed using a cluster-type substrate processing apparatus 10 in which a plurality of process furnaces 202a to 202d are provided and a plurality of process chambers 201a to 201d are respectively connected to a vacuum transport chamber 103 provided with a substrate transporter 112, for example. In other words, at least one processing of the above-described substrate processing sequence and any other processing may be performed respectively within different process chambers (process containers)(ex-situ).

In this modification, the controller 121 executes, for example, the above-described pre-process and the above-described film formation process separately in different process chambers of different process furnaces. In this case, a controller 121A that executes the pre-process in a process furnace that performs the pre-process and a controller 121B that executes the film formation process in a process furnace that performs the film formation process are controlled by the controller 121 that serves as a host computer or group management control device. In other words, the substrate processing apparatus 10 executes the pre-process of supplying the promoting agent and modifying agent and the film formation process of supplying the precursor gas and reaction gas separately in different process chambers. In either case, effects similar to those described in the above embodiments are obtained. In addition, when these processings are performed in-situ, it is possible to prevent contamination of the substrate, changes in the surface state of the substrate, etc., caused by the loading or unloading of the substrate into or out of the process chamber between the processings. Further, performing these processings in-situ allows for a reduction in a transition time between the processings. On the other hand, when these processings are performed ex-situ, the respective processings may be performed in parallel in different process chambers, thereby increasing productivity.

Even when using such a substrate processing apparatus, it is possible to perform each processing using same processing procedures and processing conditions as in the above-described embodiments and modifications, and to achieve same effects as in the above-described embodiments and modifications.

In the above embodiments, an example of supplying the promoting agent in a time divisional manner as the pre-process is described, but the present disclosure is not limited to this and may also be applied when supplying the promoting agent continuously.

Further, in the above embodiments, an example of continuously supplying the inert gas during the substrate processing process is described, but the present disclosure is not limited to this, and the inert gas may be supplied during the purge process.

Further, in the above embodiments, an example of forming a film using a batch-type substrate processing apparatus that processes a plurality of substrates at once is described. The present disclosure is not limited to the above-described embodiments, and for example, may be suitably applied to the case where a film is formed using a single-wafer type substrate processing apparatus that processes one or several substrates at once. Further, in the above embodiments, an example of forming a film using a substrate processing apparatus with a hot wall type process furnace is described. The present disclosure is not limited to the above embodiments, and may be suitably applied to the case where a film is formed using a substrate processing apparatus with a cold wall type process furnace as well.

The above-described embodiments and modifications may be combined and used as appropriate. The processing procedures and processing conditions at this time may be the same as the processing procedures and processing conditions in the above-described embodiments and modifications, for example.

The embodiments and modifications of the present disclosure are specifically described above. However, the present disclosure is not limited to the above-described embodiments and modifications, and may be changed in various ways without departing from the gist of the present disclosure.

According to the present disclosure in some embodiments, it is possible to improve characteristics of a film formed on a substrate.

While certain embodiments are described above, these embodiments presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. A method of processing a substrate (200), comprising:

(a) supplying a non-reducing promoting agent that promotes adsorption of a modifying agent containing an organic ligand to the substrate (200);
(b) supplying the modifying agent to the substrate (200); and
(c) forming a film on the substrate (200) after performing (a) and (b).

2. The method of Claim 1, wherein the modifying agent does not contain a metal element.

3. The method of Claim 1, wherein the modifying agent contains a metal element.

4. The method of Claim 1, wherein the modifying agent contains a hydrocarbon group.

5. The method of Claim 1, wherein the modifying agent contains an amine.

6. The method of Claim 1, wherein the promoting agent is oxidizing, and is a gas not containing a hydrogen element.

7. The method of Claim 1, wherein the promoting agent is an organic-based gas, and is a gas containing an alkane.

8. The method of Claim 1, wherein in (c), a gas containing a halogen element is used, and the gas containing the halogen element contains a metal element.

9. The method of Claim 1, wherein in (c), a gas containing a metal element and a halogen element is used, and the modifying agent does not contain a metal element.

10. The method of Claim 1, further comprising:

    (d) removing the promoting agent,
    wherein (a) and (d) are performed in this order a predetermined number of times.

11. The method of Claim 1, further comprising:
    (e) performing (a) and (b) in this order a predetermined number of times.

12. The method of Claim 8, wherein in (c), a reaction gas containing a hydrogen element is supplied.

13. A method of manufacturing a semiconductor device, comprising the method of Claim 1.

14. A program that causes, by a computer, a substrate processing apparatus (100, 10) to perform a process comprising:

    (a) supplying a non-reducing promoting agent that promotes adsorption of a modifying agent containing an organic ligand to a substrate (200);
    (b) supplying the modifying agent to the substrate (200); and
    (c) forming a film on the substrate (200) after performing (a) and (b).

15. A substrate processing apparatus (100, 10) comprising:

    a first gas supply system capable of supplying a non-reducing promoting agent that promotes adsorption of a modifying agent containing an organic ligand to a substrate (200);
    a second gas supply system capable of supplying the modifying agent to the substrate (200); and
    a controller (121) configured to be capable of controlling the first gas supply system and the second gas supply system to perform a process including:

        (a) supplying the promoting agent to the substrate (200);
        (b) supplying the modifying agent to the substrate (200); and
        (c) forming a film on the substrate (200) after performing (a) and (b).

FIG. 1

# FIG. 2

# FIG. 3

# FIG. 4

EP 4 585 714 A2

# FIG. 5

**EP 4 585 714 A2**

**Patent documents cited in the description**

- JP 2023107405 A